# EUROPEAN PATENT APPLICATION

(11) **EP 2 784 826 A2**
(43) Date of publication of application: **01.10.2014**
(21) Application number: 14161829.8
(22) Date of filing: 26.03.2014
(51) Int. Cl.: H01L 31/032, C23C 18/12, H01L 21/02, H01L 31/0749, H01L 31/18

(54) **Method of manufacturing thin film solar cell and thin film solar cell manufactured by the method**

(30) Priority: 27.03.2013 KR 20130033080
(71) Applicant: Samsung SDI Co., Ltd., Yongin-si, Gyeonggi-do (KR)
(72) Inventor: Kim, Hyun-Chul, Gyeonggi-do (KR); Cha, Si-Young, Gyeonggi-do (KR); Ahn, Sang-Hyuck, Gyeonggi-do (KR); Kim, Jeong-Hoon, Gyeonggi-do (KR)
(74) Representative: Mounteney, Simon James

(57) **Abstract**

A method of manufacturing a buffer layer for a thin film solar cell includes preparing a reaction solution including an ammonia compound, a zinc source, and a sulfur source at a temperature below 70°C; and immersing a substrate on which an optical absorption layer is formed in the reaction solution. The concentration of the zinc source in the reaction solution is in the range of about 0.01 M to about 0.09M.

## Description

### BACKGROUND

### 1. Technical Field

One or more embodiments of the present invention relate to thin film solar cells, to methods of manufacturing thin film solar cells, and to thin film solar cells manufactured by the method.

### 2. Description of the Related Art

As conventional energy sources, such as fossil fuels, are expected to deplete, there is growing interest in the development of alternative energy sources. Among such alternative energy sources, solar cells (which directly convert solar energy into electric energy using semiconductor materials) have been highlighted for use as next generation batteries.

The basic structure of a solar cell includes a diode having pn junctions, and solar cells are classified according to the material of the optical absorption layer. Solar cells including optical absorption layers made of silicon may be classified as crystalline (monocrystal, polycrystal) substrate solar cells or thin film (amorphous, polycrystal) solar cells. Examples of solar cells may include thin film solar cells including optical absorption layers made of S-substituted copper-indium-gallium-selenide(CIGS)-based compounds or S-unsubstituted CdTe, III - V group solar cells, dye-sensitized solar cells, and organic solar cells. CIGS-based thin film solar cells may include a CdS buffer layer or a Cd-free buffer layer (in which Cd is eliminated since Cd is harmful to the human body). The Cd-free buffer layer may be formed by Chemical Bath Deposition (CBD).

CBD has been widely used to form Cd-free buffer layers and includes washing impurities from the surface of the optical absorption layer, and substituting and etching a zinc source on a vacancy region near the surface of the optical absorption layer. The composition of a buffer layer formed by CBD may vary, and such a buffer layer generally has a thickness in the range of 50 nm or less.

However, in solar cells including Cd-free buffer layers, a longer period of time is needed to form the film than in solar cells including CdS buffer layers, and the reaction solution cannot be used continuously and must be replaced with fresh solution, thereby increasing cost and environmental damage.

### SUMMARY

According to one or more embodiments of the present invention, a method of manufacturing a buffer layer for a thin film solar cell allows use of a reaction solution for a long time. The present invention provides a method as defined in any of claims 1 to 14 and a solar cell as defined in claim 15.

According to one or more embodiments of the present invention, a thin film solar cell maintains good electric properties for a long time.

Additional aspects will be set forth in part in the description which follows and, in part, will be apparent from the description, or may be learned by practice of the presented embodiments.

According to one or more embodiments of the present invention, a method of manufacturing a thin film solar cell includes preparing a reaction solution including an ammonia compound, a zinc source, and a sulfur source, which reaction solution is kept at below 70°C; and immersing a substrate (on which an optical absorption layer is formed) in the reaction solution. The concentration of the zinc source is in the range of about 0.01 M to about 0.09M.

According to one or more embodiments of the present invention, the reaction solution may be kept at a temperature in the range of about 60°C to about 70°C.

According to one or more embodiments of the present invention, preparation of the reaction solution may preferably include separately preparing a first solution containing the sulfur source and a second (mixed) solution containing an ammonia compound and the zinc source, and then mixing the two solutions.

According to one or more embodiments of the present invention, preparation of the first solution containing the sulfur source may preferably include stirring the sulfur source in deionized water at a temperature of about 70°C to about 90°C.

According to one or more embodiments of the present invention, preparation of the second (mixed) solution of the ammonia compound and the zinc source may preferably include mixing the ammonia compound and the zinc source at room temperature.

According to one or more embodiments of the present invention, the concentration of the ammonia compound may preferably be in the range of about 1.0M to about 5.0M.

According to one or more embodiments of the present invention, the concentration of the sulfur source in the reactant solutionmay preferably be in the range of about 0.1 M to about 0.7M.

According to one or more embodiments of the present invention, the method may preferably further include washing the substrate (on which an optical absorption layer is formed) after immersing the substrate in the reaction solution.

According to one or more embodiments of the present invention, the method may preferably further include drying the substrate after washing.

According to one or more embodiments of the present invention, the light transmittance of the reaction solution may preferably be maintained at 60% or higher from initiation of the reaction to four hours thereafter.

In another aspect of the present invention, a thin film solar cell includes: a substrate; a rear electrode layer on the substrate; an optical absorption layer on the rear electrode layer; a buffer layer formed according to the above-mentioned method on the optical absorption layer; and a transparent electrode layer on the buffer layer.

In an aspect of the present invention, the method for manufacturing a thin film solar cell in which a reaction solution is continuously usable for a long period of time includes preparing the reaction solution with adjusted concentrations of the Zn source and temperature. Thin film solar cells manufactured from the method can maintain good electric properties for a long period of time.

### BRIEF DESCRIPTION OF THE DRAWINGS

These and/or other aspects will become apparent and more readily appreciated from the following description of some embodiments when taken in conjunction with the accompanying drawings in which:
FIG. 1 is a flow chart illustrating a method of manufacturing a buffer layer for a thin film solar cell according to an embodiment of the present invention;
FIG. 2 is a flow chart illustrating a process for preparing a reaction solution in the manufacturing method for forming a buffer layer for a thin film solar cell according an embodiment of the present invention;
FIG. 3 is a schematic diagram illustrating a thin film solar cell according an embodiment of the present invention; and
FIG. 4 is a graph comparing light transmittance vs. time of the reaction solutions used to manufacture the buffer layer of a thin film solar cell manufactured according to Examples 1-4 and Comparative Examples 1-4.

### DETAILED DESCRIPTION

Reference will now be made in detail to certain embodiments, some examples of which are illustrated in the accompanying drawings, wherein like reference numerals refer to like elements throughout. However, the present embodiments may have different forms and should not be construed as limited to the descriptions set forth herein. Accordingly, the presented embodiments are described below, with reference to the figures, to explain aspects of the present invention. As used herein, the term "and/or" includes any and all combinations of one or more of the associated listed items. Expressions such as "at least one of," when preceding a list of elements, modify the entire list of elements and do not modify the individual elements of the list.

Hereinafter, a method of manufacturing a buffer layer for a thin film solar cell according to an embodiment of the present invention, and a thin film solar cell including the buffer layer manufactured by the method will be described. The embodiments described herein should be considered in a descriptive sense only and not for purposes of limitation. The descriptions of features or aspects within each embodiment should typically be considered as available for other similar features or aspects in other embodiments.

In the drawings, each of the constitutional features is exaggerated, abbreviated or schematically shown for the purpose of convenience and to clarify certain aspects of this disclosure of the present invention, and the size of each constitutional feature is not necessarily to scale and may not entirely reflect the actual size. Also, in the description, when a first constitutional feature is described as formed "on" another constitutional feature, the first constitutional feature may be directly formed on the other constitutional feature, or may be indirectly formed on the other constitutional feature (i.e., there may be an intervening feature). In addition, in the description, when a first feature is referred to as "upper" or "lower" with respect to another feature, the first feature may be directly "upper" or "lower" with respect to the other feature, or may be indirectly "upper" or "lower" with respect to the other feature (i.e., there may be an intervening feature).

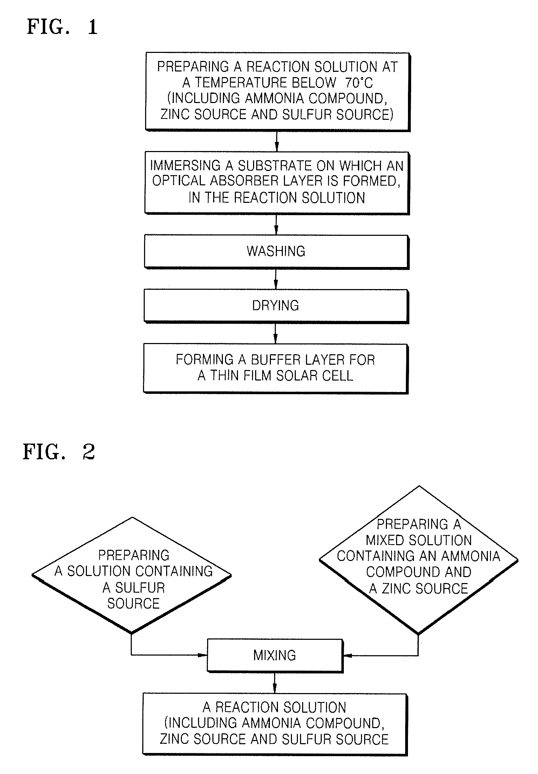

FIG. 1 is a flow chart illustrating a method of manufacturing a buffer layer for a thin film solar cell according to an embodiment of the present invention. Referring to FIG. 1, in an embodiment of the invention, the method of manufacturing the buffer layer includes preparing a reaction solution including an ammonia compound, a zinc source, and a sulfur source at a temperature below 70°C; and immersing a substrate on which an optical absorption layer is formed in the reaction solution. The zinc source is preferably present in a solution. The concentration of the zinc source in the reaction solution may be in the range of about 0.01 M to about 0.09M.

For example, the reaction solution may preferably be prepared in a temperature range of about 60°C to about 70°C, preferably 61°C to 69°C, more preferably 62°C to 68°C, e.g. 62.5°C, 63.0°C, 63.5°C, 64.0°C, 64.5°C, 65.0°C, 65.5°C, 66.0°C, 66.5°C, 67.0°C and 67.5°C.

Conventionally, the temperature of the reaction solution used in methods of manufacturing the buffer layer for a thin film solar cell is about 70°C to about 95°C. However, here, due to the fast reaction rate of the reaction solution, the reaction solution may change into a colloid, and particles in the colloid may repeatedly attach to and detach from the surface of the optical absorption layer, thereby raising the problem of a shunt path. Accordingly, the reaction solution cannot be used continuously, making it necessary to replace the solution with fresh solution, which increases cost and environmental damage.

In the method of manufacturing a buffer layer for a thin film solar cell as described above, the light transmittance of the reaction solution is maintained at about 60% or higher from initiation of the reaction, thereby constantly controlling the reaction rate. As a result, a thin film solar cell including the buffer layer manufactured by the method can maintain good electric properties for a long period of time.

FIG. 2 is a flow chart illustrating a process for preparing the reaction solution for use in the manufacturing method for forming a buffer layer for a thin film solar cell according to an embodiment of the present invention. Referring to FIG. 2, preparing the reaction solution may preferably include separately preparing a first solution containing the sulfur source and a second (mixed) solution containing the ammonia compound and the zinc source, and then mixing the two solutions.

Preparing the first solution including the sulfur source may preferably include stirring the sulfur source in deionized water at a temperature of about 70°C to about 90°C, preferably 75°C to about 85°C, more preferably 80°C to about 85°C.

Preparing the second (mixed) solution containing the ammonia compound and the zinc source may preferably include mixing the ammonia compound and the zinc source at room temperature. The ammonia compound and the zinc source are preferably both present in the form of solutions which are then mixed to form the second solution.

By preparing the first solution including the sulfur source at a temperature about 10°C to about 20°C higher than that of the reaction solution, and then mixing it with the second (mixed) solution containing the ammonia compound and the zinc source at room temperature, the reaction temperature can be constantly regulated to below 70°C from initiation of the reaction in preparing the reaction solution.

In addition, considering that an increase in the temperature of the ammonia compound and the zinc source would lead to a change in the concentration of the ammonia compound due to volatilization, the ammonia compound and the zinc source are preferably mixed at room temperature. This enables binding between Zn²⁺ of the zinc source with the ammonia compound at the early stages in the preparation of the reaction solution, which enables proper control of the formation of ZnO.

The ammonia compound may preferably be in the form of an ammonia compound solution, preferably an aqueous ammonia solution (e.g., NH₄OH) or the like.

The concentration of the ammonia compound in the reaction solution may be in the range of about 1.0M to about 5.0M.

When the ammonia compound has a concentration in the above range, it may be possible to control the shunt path by removing copper ammonium complexes such as [Cu(NH₄)₃]²⁺ or [Cu(NH₄)₂]²⁺ in CuxSe or Cu rich sites present on the surface of the optical absorption layer. Also, the band alignment property may be improved. Further, the ammonia compound can form a ligand by binding to Zn²⁺ of the zinc source, thereby inducing binding between zinc and the surface of the optical absorption layer, and also enabling control of the rate of formation of the buffer layer on the surface of the optical absorption layer.

The zinc source may preferably include a zinc salt or a zinc compound. For example, the zinc source may preferably be at least one of ZnSO₄, ZnCl₂, Zn₂(CH₃COO), Zn(NO₃)₂, or a hydride thereof. The zinc source may be substituted or diffused into the surface of the optical absorption layer, thereby promoting growth of the buffer layer.

The concentration of the zinc source in the reaction solution may preferably be in the range of about 0.01 M to about 0.07M, preferably 0.020M to 0.060M, more preferably 0.025M to 0.055M, e.g. 0.020M, 0.025M, 0.030M, 0.035M, 0.040M, 0.045M, 0.050M, 0.055M, 0.060M and 0.065M.

When the concentration of the zinc source is within the above range, the thickness of the buffer layer of the thin film solar cell may be increased while minimally affecting light transmittance. More specifically, even when the concentration of the zinc source is rapidly increased up to the maximum limit of the above range while the reaction solution is maintained at a temperature below 70°C, a light transmittance of the reaction solution of about 70% may be maintained for about 1 hour. A change may occur in the light transmittance of the reaction solution due to particle growth between 1 hour and 1.5 hours, but after 1.5 hours, the change in light transmittance may become small.

The sulfur source may preferably include a thiourea-based compound. The sulfur source enables formation of a uniform buffer layer on the optical absorption layer. The concentration of the sulfur source in the reaction solution may preferably be in the range of about 0.1 M to about 0.7M, preferably 0.40M to 0.60M, preferably 0.50M to 0.58M.

The substrate on which the optical absorption layer is formed is preferably immersed into the reaction solution for between 5 minutes and 20 minutes, preferably between 7 minutes and 15 minutes, most preferably 10 minutes.

The method may preferably further include washing the substrate on which the optical absorption layer is formed, after immersing the substrate in the reaction solution. The washing may preferably include a first washing at 50°C using an alkali solution with a concentration of 5 wt % or less, and a second washing using deionized water. The alkali solution may preferably be an ammonia compound.

When the concentration of the zinc source is 0.1M or greater, if the substrate immersed in the reaction solution is washed with deionized water only, a significant change in pH may occur in the ammonia compound and the sulfur source contained in the reaction solution as well as on the surface of the optical absorption layer at the time of the film-forming reaction. Also, the composition and thickness of the buffer layer may become non-uniform due to the easy formation of stains when the substrate immersed in the reaction solution reacts with oxygen, thereby deteriorating the electric properties of a thin film solar cell including the buffer layer. Therefore, the electric properties of the thin film solar cell may be improved by substantially preventing the formation of stains on the buffer layer by performing the first washing at 50°C using an alkali solution with a concentration of 5 wt % or less before the second washing using deionized water.

In an embodiment, the method may preferably further include drying the substrate after the washing. In an embodiment, the drying may preferably include drying in an inert gas atmosphere. In an embodiment, the inert gas may preferably include a N₂ gas, etc.

In an embodiment, a buffer layer including ZnS, ZnO, or ZnS (O, OH) may preferably be formed on the substrate on which the optical absorption layer is formed. Unlike a CdS buffer layer, the buffer layer does not contain harmful Cd and is thus advantageous from an environmental perspective. Also, the buffer layer may be formed thin. In an embodiment, the thickness of the buffer layer may preferably be in the range of about 10nm to about 50nm.

In an embodiment, the reaction solution may be usable for up to 6 hours. For example, the light transmittance of the reaction solution may be maintained at a level of 60% or higher for up to 4 hours, thereby enabling a constant reaction rate of the reaction solution to be maintained and enabling use of the reaction solution for a long period of time.

In another aspect of the present invention, a thin film solar cell includes: a substrate; a rear electrode layer on the substrate; an optical absorption layer on the rear electrode layer; a buffer layer formed according to the above-described method on the optical absorption layer; and a transparent electrode layer on the buffer layer.

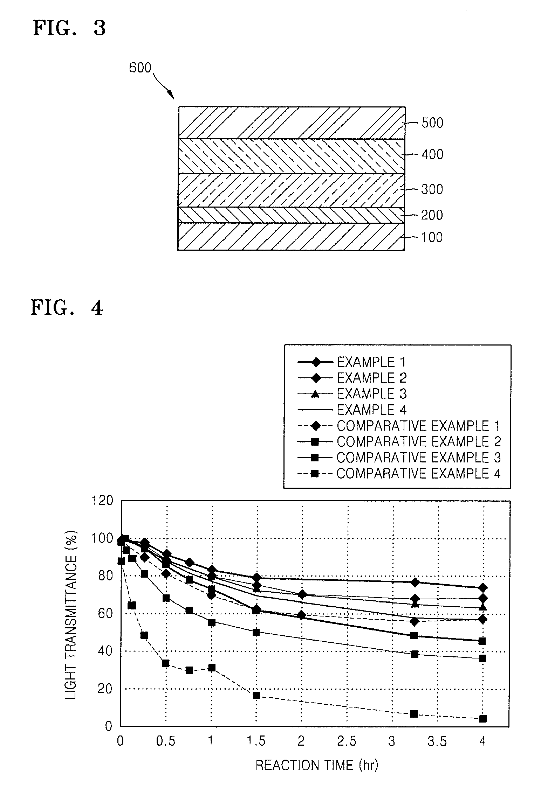

FIG. 3 is a diagram illustrating a thin film solar cell according to an embodiment of the present invention. Referring to FIG. 3, the thin film solar cell includes a substrate 100; a rear electrode layer 200 on the substrate 100; an optical absorption layer 300 on the rear electrode layer; a buffer layer 400 on the optical absorption layer 300; and a transparent electrode layer 500 on the buffer layer 400.

First, the substrate 100 may preferably be formed using a glass or polymer with good light transmittance. For example, the glass may be sodalime glass or high-strain point soda glass, and the polymer may include polyimide, but the glass and polymer are not limited thereto. In addition, the glass substrate may be formed using reinforced glass with a low iron content to increase the transmittance rate of sunlight as well as to protect the internal elements of the substrate from external shock, etc. For example, when a sodalime glass with a low iron content is used, Na ions can elute out of the glass during high temperature processes performed at 500°C or above, thereby further improving the efficiency of the optical absorption layer 300.

The rear electrode layer 200 may be formed using a metal material having good conductivity and light reflectivity (such as, for example, molybdenum (Mo), aluminum (Al) or copper (Cu)) to collect charges formed by a photoelectric effect, and to reflect the light transmitted through the optical absorption layer 300 so that it can be reabsorbed. In particular, the rear electrode layer 200 may include Mo due to its high conductivity, ohmic contact with the optical absorption layer 300, and stability at high temperatures in a selenium (Se) atmosphere.

The rear electrode layer 200 may be formed by coating a conductive paste on the substrate 100 followed by heat treatment, or any other available plating method. For example, the rear electrode layer 200 may be formed by sputtering using a Mo target.

The rear electrode layer 200 may have a thickness of about 200nm to about 500nm. For example, rear electrode layer 200 may be divided into a plurality of layers by a first separation groove (not shown). The first separation groove may be a groove formed in a direction parallel to a direction of the substrate 100.

The first separation groove may be formed by first forming the rear electrode layer 200 on the substrate 100 and then dividing the rear electrode layer 200 by a first patterning of the layer 200 into a plurality of layers. The first patterning may be performed by laser scribing, for example. During the laser scribing, part of the rear electrode layer 200 is evaporated by laser irradiation incident on the substrate 100 from below the substrate 100, and the first separation groove (which divides the rear electrode layer 200 into a plurality of layers at regular intervals) is formed by laser scribing.

Meanwhile, the rear electrode layer 200 may be doped with alkali ions, such as Na. For example, during the growth of the optical absorption layer 300, the alkali ions doped on the rear electrode layer 200 are introduced into the optical absorption layer 300, thereby producing a positive structural effect on the optical absorption layer 300 and improving its conductivity. As such, the open circuit voltage (V_{oc}) of the solar cell 600 can be increased, thereby improving the efficiency of the solar cell 600.

Furthermore, the rear electrode layer 200 may be formed as multiple layers to improve the resistance characteristics of the rear electrode layer 200 itself, as well as to improve adherence to the substrate 100.

The optical absorption layer 300 may be a P type conductive layer including a Cu(In,Ga)(Se,S)₂ compound substituted with S or a Cu-In-Ga-Se(CIGS)-based compound not substituted with S, and may absorb sun light. The optical absorption layer 300 may have a thickness of about 0.7 µm to about 2µm, and may be formed within the separation groove that divides the rear electrode layer 200.

The optical absorption layer 300 may be formed by a co-evaporation method in which Cu, In, Ga, Se, etc., are loaded into a small electric furnace inside a vacuum chamber and then heated. Alternatively, the optical absorption layer 300 may be formed by a sputtering/selenization method in which a CIGS-based metal precursor film is formed on the rear electrode layer 200 using a Cu target, an In target, and a Ga target, and then heat treating in a H₂Se gas atmosphere to allow the metal precursor film to react with Se, thereby forming the optical absorption layer 300. In another alternative, the optical absorption layer 300 may be formed by an electro-deposition method, a metal organic chemical vapor deposition method (hereinafter, MOCVD), etc.

The buffer layer 400 reduces both the band gap between the optical absorption layer 300 (P type) and the transparent electrode layer 500 (N type) and the recombination of electrons and holes that may occur at the interface of the transparent electrode layer 500. The buffer layer 400 may be formed by chemical bath deposition (CBD) as described above.

Meanwhile, the optical absorption layer 300 and the buffer layer 400 may be divided into a plurality of layers by a second separation groove (not shown). The second separation groove may be formed in a direction parallel to the first separation groove but in a different location from the first separation groove, and the upper side of the rear electrode layer 200 is exposed to the outside by the second separation groove.

After forming the optical absorption layer 300 and the buffer layer 400, the second separation groove (not shown) is formed by performing a second patterning. The second patterning may be performed by mechanical scribing, in which a sharp device (such as a needle) is moved in parallel with the first separation groove but from a position separated from the first separation groove. However, the present invention is not limited thereto, and a laser may also be used.

The second patterning divides the optical absorption layer 300 into a plurality of layers, and the second separation groove formed by the second patterning extends to the upper side of the rear electrode layer 200, thereby exposing the backside electrode layer 200 to the outside.

The transparent electrode layer 500 forms a P-N junction with the optical absorption layer 300. Further, the transparent electrode layer 500 includes transparent conductive materials such as ZnO:B, AZO, ITO or IZO, and traps charges formed by the photoelectric effect. The transparent electrode layer 500 may be formed by metal organic chemical vapor deposition (MOCVD), low pressure chemical vapor deposition (LPCVD) or sputtering.

Further, although not shown in the figures, the upper side of the transparent electrode layer 500 may be textured in order to reduce the reflection of sun light incident thereon and increase the light absorption to the optical absorption layer 300.

The transparent electrode layer 500 may also be formed within the second separation groove, and by contacting the rear electrode layer 200 exposed by the second separation groove, the transparent electrode layer 500 can be electrically connected to the optical absorption layer 300 (which is divided into a plurality of layers by the second separation groove).

The transparent electrode layer 500 may be divided into a plurality of layers by a third separation groove (not shown) formed in a location different from the locations of the first separation groove and the second separation groove. The third separation groove may be formed in a direction parallel to the directions of the first separation groove and the second separation groove, and may extend to the upper face of the rear electrode layer 200. The third separation groove may be filled with an insulating material, such as air.

The third separation groove may be formed by performing a third patterning. The third patterning may be performed by mechanical scribing, and the third separation groove formed by the third patterning may extend to the upper side of the rear electrode layer 200, thereby forming a plurality of photoelectric conversion units. In addition, the third separation groove may be filled with air, thus forming an insulation layer.

Although not shown in the figures, the upper side of the transparent electrode layer 500 may have a textured surface. As used herein, "textured surface" refers to a rugged pattern on the upper side, which can be formed by a physical or chemical method. When the surface of the transparent electrode layer 500 is rough due to texturing, the reflection rate of incident light thereon decreases, thereby increasing the amount of trapped light. Accordingly, texturing has the effect of reducing optical loss.

The present disclosure is further illustrated by reference to the following examples and comparative examples. However, it shall be understood that these examples and comparative examples are presented for illustrative purposes only, and they do not limit the present invention in any way.

### Manufacture of a thin film solar cell

### Example 1

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was then heat treated in an H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was formed on the optical absorption layer by chemical bath deposition (CBD) as follows.

First, deionized water and SC(NH₂)₂ were mixed by stirring at 77.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were added into a reactor and mixed to obtain a reaction solution at 62.5°C, with the initial concentrations in the reaction solution for the above reactants being: 0.55M SC(NH₂)₂, 2.5M NH₄OH and 0.025M ZnSO₄.7H₂O.

Then, the substrate on which the optical absorption layer was formed was immersed in the reaction solution for 10 minutes.

The substrate was washed with deionized water, and dried in a N₂ gas atmosphere for 5 minutes, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Example 2

A soda lime glass substrate was prepared. The soda lime glass substrate had a thickness of about 1 mm and included a Mo rear electrode layer sheathed thereon. A CuGa target and an In target were respectively sputtered on the substrate, and the soda lime glass substrate was heat treated in an H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorber layer by chemical bath deposition (CBD) as follows.

First, deionized water and SC(NH₂)₂ were mixed by stirring at 82.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were added into a reactor and mixed to obtain a reaction solution at 67.5°C with the initial concentrations in the reaction solution for the above reactants being: 0.55M SC(NH₂)₂, 2.5M NH₄OH and 0.025M ZnSO₄.7H₂O.

Then, the substrate on which the optical absorption layer was formed, was immersed into the reaction solution for 10 minutes. The substrate was then washed with deionized water, and dried in a N₂ gas atmosphere for 5 minutes, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Example 3

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was heat treated in a H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorber layer by chemical bath deposition (CBD) as follows.

First, deionized water and SC(NH₂)₂ were mixed by stirring at 77.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. The SC(NH₂)₂ solution and the mixed solution of NH₄OH and ZnSO₄.7H₂O were then added into a reactor and mixed to obtain a reaction solution at 62.5°C with the initial concentrations in the reaction solution for the above reactants being: 0.55M SC(NH₂)₂, 2.5M NH₄OH and 0.055M ZnSO₄.7H₂O.

Then, the substrate on which the optical absorption layer was formed was immersed into the reaction solution for 10 minutes. The substrate was washed with deionized water, and dried in a N₂ gas atmosphere for 5 minutes, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Example 4

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was heat treated in a H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorber layer by chemical bath deposition (CBD) as follows.

First, deionized water and SC(NH₂)₂ were mixed by stirring at 77.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were added into a reactor and mixed to obtain a reaction solution at 62.5°C, with the initial concentrations in the reaction solution for the above reactants being: 0.55M SC(NH₂)₂, 2.5M NH₄OH and 0.085M ZnSO₄.7H₂O.

Then, the substrate on which the optical absorption layer was formed, was immersed into the reaction solution for 10 minutes. The substrate was washed with deionized water, and dried in a N₂ gas atmosphere for 5 minutes, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Comparative Example 1

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was heat treated in an H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorber layer by chemical bath deposition (CBD) as follows.

First, deionized water and SC(NH₂)₂ were mixed by stirring at 82.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were added into a reactor and mixed to obtain a reaction solution at 72.5°C, with the initial concentrations in the reaction solution for the above reactants being: 0.55M SC(NH₂)₂, 2.5M NH₄OH and 0.025M ZnSO₄.7H₂O.

Then, the substrate on which the optical absorption layer was formed was immersed into the reaction solution for 10 minutes. Then, the substrate was washed with a 5wt% NH₄OH solution, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Comparative Example 2

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was heat treated in an H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorption layer by chemical bath deposition (CBD) as follows.

First, deionized water and SC(NH₂)₂ were mixed by stirring at 77.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were added into a reactor and mixed to obtain a reaction solution at 62.5°Cwith the initial concentrations in the reaction solution for the above reactants being: 0.55M SC(NH₂)₂, 2.5M NH₄OH and 0.1M ZnSO₄.7H₂O.

Then, the substrate on which the optical absorption layer was formed was immersed into the reaction solution for 10 minutes. The substrate was washed with a 5wt% NH₄OH solution, thereby forming a buffer layer with a thickness of 0.5nm on the optical absorption layer.

Then, a ZnO transparent electrode layer was formed on the buffer layer by MOCVD, thereby completing the manufacture of a thin film solar cell.

### Comparative Example 3

A soda lime glass substrate was prepared. The soda lime glass substrate had a thickness of about 1 mm and included a Mo rear electrode layer sheathed thereon. A CuGa target and an In target were respectively sputtered on the soda lime glass substrate, and the soda lime glass substrate was heat treated under H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was formed on the optical absorption layer by chemical bath deposition (CBD) as follows.

First, deionized water and SC(NH₂)₂ were mixed by stirring at 82.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. Then, the SC(NH₂)₂ solution and the mixed solution of NH₄OH and ZnSO₄.7H₂O were then added into a reactor and mixed to obtain a reaction solution at 67.5°C, with the initial concentrations in the reaction solution for the above reactants being: 0.55M SC(NH₂)₂, 2.5M NH₄OH and 0.1M ZnSO₄.7H₂O.

Then, the substrate on which the optical absorption layer was formed was immersed into the reaction solution for 10 minutes. The substrate was washed with a 5wt% NH₄OH solution, thereby forming a buffer layer with a thickness of 0.5nm on the optical absorber layer.

Then, a ZnO transparent electrode layer was formed on the buffer layer by MOCVD, thereby completing the manufacture of a thin film solar cell.

### Comparative Example 4

A soda lime glass substrate was prepared. The soda lime glass substrate had a thickness of about 1 mm and included a Mo rear electrode layer sheathed thereon. A CuGa target and an In target were respectively sputtered on the soda lime glass substrate and then, the soda lime glass substrate was heat treated under an H₂Se and H₂S atmosphere at 400°C for 20 minutes and at 550°C for 60 minutes, respectively, thereby forming an optical absorption layer having a composition of CuIn_{0.7}Ga_{0.3}SSe₂.

A buffer layer was then formed on the optical absorption layer by chemical bath deposition (CBD) as follows.

First, deionized water and SC(NH₂)₂ were mixed by stirring at 87.5°C to obtain a SC(NH₂)₂ solution. Separately, solutions of NH₄OH and ZnSO₄.7H₂O were mixed at room temperature to obtain a mixed solution of NH₄OH and ZnSO₄.7H₂O. The SC(NH₂)₂ solution and the mixed solution of NH₄OH and ZnSO₄.7H₂O were then added into a reactor and mixed to obtain a reaction solution at 67.5°C, with the initial concentrations in the reaction solution for the above reactants being: 0.55M SC(NH₂)₂, 2.5M NH₄OH and 0.1M ZnSO₄.7H₂O.

Then, the substrate on which the optical absorption layer was formed was immersed into the reaction solution for 10 minutes. The substrate was washed with a 5wt% NH₄OH solution thereby forming a buffer layer with a thickness of 0.5nm on the optical absorber layer.

A ZnO transparent electrode layer was formed on the buffer layer by MOCVD, thereby completing the manufacture of a thin film solar cell.

### Evaluation Example 1: Evaluation of Electric Properties

Changes in the light transmittances of the reaction solutions used to form the buffer layers of the thin film solar cells manufactured in Examples 1-4 and Comparative Examples 1-4 were measured over a time period of 0-4 hours using a light transmittance measurement device (UV Vis 3000, Hitachi). The results are shown in FIG. 4 and Table 1 below.

**Table 1**

| Category | Light Transmittance (%) |
|---|---|
| Example 1 | 73.1 |
| Example 2 | 68.1 |
| Example 3 | 63.8 |
| Example 4 | 59.3 |
| Comparative Example 1 | 57.1 |
| Comparative Example 2 | 45.0 |
| Comparative Example 3 | 36.2 |
| Comparative Example 4 | 4.1 |

Referring to FIG. 4 and Table 1, the light transmittance of the reaction solutions used to form the buffer layers of the thin film solar cells manufactured in Examples 1-4 were higher than those of the reaction solutions used to form the buffer layers of the thin film solar cells manufactured in Comparative Examples 1-4.

Furthermore, as shown in Example 2 and Comparative Example 1, although the concentrations of the ammonia compound, the zinc source, and the sulfur source are the same, the light transmission of the reaction solution used to form the buffer layer for the thin film solar cell prepared in Example 2 (in which the temperature of the reaction solution was below 70°C) was about 11.0% higher than the light transmission of the reaction solution used in Comparative Example 1 (in which the temperature of the reaction solution was 70°C or higher).

While certain embodiments of the present invention have been described herein, those of ordinary skill in the art will recognize that various modifications may be made to the described embodiments without departing from the scope of the present invention, as defined in the appended claims. As such, descriptions of features or aspects within each embodiment should typically be considered as being available for other similar features or aspects in other embodiments.

## Claims

1. A method of manufacturing a buffer layer for a thin film solar cell, the method comprising:
preparing a reaction solution at a temperature below 70°C, the reaction solution comprising an ammonia compound, a zinc source, and a sulfur source; and
immersing a substrate having an optical absorption layer thereon in the reaction solution,
wherein a concentration of the zinc source in the reaction solution is in a range of about 0.01 M to about 0.09M.

2. The method of claim 1, wherein the reaction solution is prepared at a temperature in the range of about 60°C to about 70°C.

3. The method of claim 1 or claim 2, wherein the preparing the reaction solution includes preparing a first solution comprising the sulfur source and separately preparing a second solution comprising the ammonia compound and the zinc source, and mixing the first and second solutions.

4. The method of claim 3, wherein the preparing the first solution comprises stirring the sulfur source in deionized water at a temperature of about 70°C to about 90°C.

5. The method of claim 3, wherein the preparing the second solution includes mixing the ammonia compound and the zinc source at room temperature.

6. The method of claim 1, wherein a concentration of the ammonia compound in the reaction solution is in a range of about 1.0M to about 5.0M.

7. The method of any of claims 1 to 6, wherein the zinc source is at least one selected from the group consisting of ZnSO₄, ZnCl₂, Zn₂(CH₃COO), Zn(NO₃)₂, and hydrides thereof.

8. The method of any of claims 1 to 7, wherein a concentration of the zinc source is in a range of about 0.01 M to about 0.07M.

9. The method of any of claims 1 to 8, wherein the sulfur source comprises a thiourea-based compound.

10. The method of any of claims 3 to 9, wherein a concentration of the sulfur source in the reaction solution is in the range of about 0.1 M to about 0.7M.

11. The method of any of claims 1 to 10, wherein the method further comprises washing the substrate after immersing the substrate in the reaction solution.

12. The method of any of claims 1 to 11, wherein the method further includes drying the substrate after the washing.

13. The method of claim 12, wherein the drying includes drying under an inert gas atmosphere.

14. The method of any of claims 1 to 13, wherein the substrate having the optical absorption layer thereon further comprises a second buffer layer of ZnS, ZnO, or ZnS (O, OH) on the substrate optionally, wherein a thickness of the second buffer layer is in a range of about 10nm to about 50nm.

15. A thin film solar cell comprising:
a substrate;
a rear electrode layer on the substrate;
an optical absorption layer on the rear electrode layer;
the buffer layer manufactured according to any of claims 1 to 14 on the optical absorption layer; and
a transparent electrode layer on the buffer layer.
